(19) Europäisches Patentamt
European Patent Office
Office européen des brevets

(11) **EP 1 875 308 B1**

(12) **FASCICULE DE BREVET EUROPEEN**

(45) Date de publication et mention
de la délivrance du brevet:
**09.11.2011 Bulletin 2011/45**

(21) Numéro de dépôt: **06743837.4**

(22) Date de dépôt: **24.04.2006**

(51) Int Cl.:
***G03F 1/00*** (2006.01)

(86) Numéro de dépôt international:
**PCT/FR2006/050380**

(87) Numéro de publication internationale:
**WO 2006/114544 (02.11.2006 Gazette 2006/44)**

(54) **STRUCTURE DE BLANC DE MASQUE AJUSTABLE POUR MASQUE EUV A DECALAGE DE PHASE**

VERSTELLBARE MASKENROHLINGSSTRUKTUR FÜR EINE EUV-PHASENSCHIEBERMASKE

ADJUSTABLE MASK BLANK STRUCTURE FOR AN EUV PHASE-SHIFT MASK

(84) Etats contractants désignés:
**DE FR GB IT**

(30) Priorité: **26.04.2005 FR 0551078**

(43) Date de publication de la demande:
**09.01.2008 Bulletin 2008/02**

(73) Titulaire: **Commissariat à l'Énergie Atomique
et aux Énergies Alternatives
75015 Paris (FR)**

(72) Inventeur: **QUESNEL, Etienne
F-38240 Meylan (FR)**

(74) Mandataire: **Poulin, Gérard et al
BREVALEX
95 rue d'Amsterdam
75378 Paris Cedex 8 (FR)**

(56) Documents cités:
**EP-A- 0 660 184      US-A1- 2003 031 937
US-A1- 2003 091 910      US-B1- 6 645 679**

EP 1 875 308 B1

## Description

## DOMAINE TECHNIQUE ET ART ANTÉRIEUR

L'invention concerne le domaine des composants optiques, et en particulier, mais pas uniquement, les blancs de masque et masques de lithographie pour application microélectronique, par exemple les masques EUV fonctionnant en réflexion ou encore les masques à décalage de phase.

Le domaine spectral d'application est, préférentiellement, celui de l'Extrême Ultra-Violet (EUV : λ = 10-30 nm).

Un exemple de domaine d'application est la lithographie EUV en microélectronique.

L'invention concerne également les fonctions optiques EUV demandant un ajustement fin de l'épaisseur de la structure optique dans une gamme de variation comprise entre 1 Å et quelques nanomètres.

De manière générale, dans le domaine des masques de lithographie, la réduction de la taille des motifs à imprimer sur plaque de silicium est obtenue, d'une part par réduction des longueurs d'onde d'insolation, d'autre part par optimisation de la structure optique des masques.

Dans le principe, l'objectif est de projeter sur la résine recouvrant la plaque de silicium des motifs de plus en plus petits et dont les contours soient les plus nets possible.

Le but est d'obtenir, après révélation des zones de résine exposées, des profils de résine gravée dont les bords soient peu rugueux, avec des flancs à pente bien maîtrisée.

La projection des motifs, la maîtrise de leur forme et de leur positionnement sur la plaque de silicium sont assurés en plaçant un masque entre la source de lumière d'insolation et la plaque à insoler.

Ainsi, un meilleur contrôle des profils de gravure est obtenu grâce, notamment, à l'utilisation de masques particuliers appelés masques à décalage de phase (ou masque PSM « Phase shift mask »). Ces masques permettent, par ailleurs, d'obtenir des tailles minimales de motif (résolution) très petites, équivalentes à la moitié de la longueur d'onde d'insolation.

Dans le domaine de la lithographie EUV, la réduction des motifs à des tailles de 22 nm, voire moins, imposent l'utilisation de tels masques à décalage de phase.

Le principe d'un masque EUV classique est de projeter le motif à insoler non par transmission, comme dans la lithographie visible et UV, mais par réflexion.

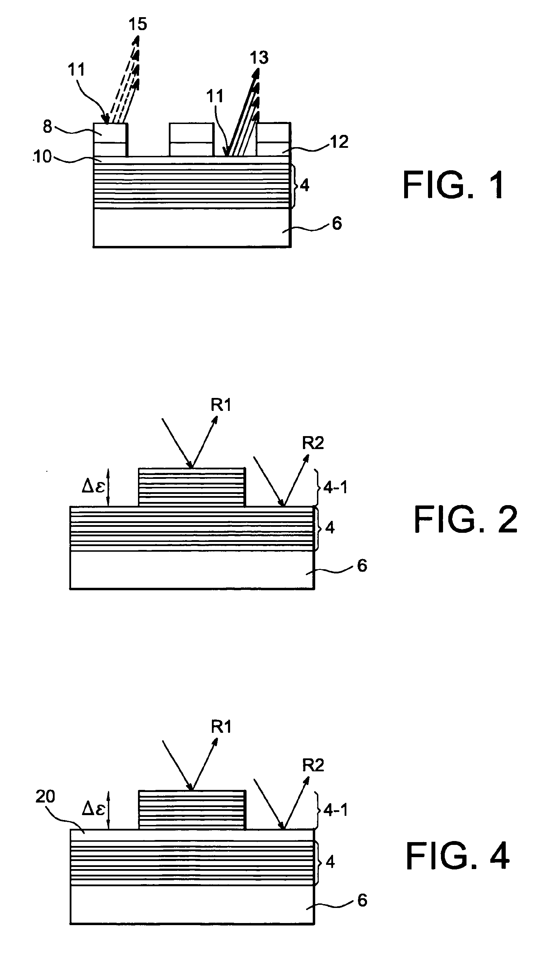

Pour cela, la structuration de surface du masque consiste à délimiter sur sa surface des zones réfléchissantes et absorbantes, comme illustré sur la figure 1.

Sur cette figure, les références 10 et 12 désignent respectivement une couche de protection et une couche tampon, et la référence 8 une couche absorbante. Un miroir multicouche 4 est formé sur un substrat 6.

Un rayonnement incident 11 se décompose en une partie réfléchie 13 et une partie 15, dont l'intensité est atténuée par rapport à la partie 13, du fait d'une absorption par la couche 8.

La surface réfléchissante correspond alors, au facteur de grossissement près, au motif à insoler sur la résine.

Dans les zones réfléchissantes, la fonction miroir est assurée par le revêtement multicouche 4 composé d'un empilement périodique de bicouches Mo/Si (typiquement 40 bicouches, chaque bicouche comportant une couche de Mo de 2,8 nm et une couche de Si de 4,1 nm pour une longueur d'onde recherchée de 13,4 nm). Il y a donc création et délimitation de zones d'impression (motifs) par modulation de la réflexion optique de la surface selon la présence, ou non, de la couche absorbante 8.

Dans le cas d'un masque PSM EUV, utilisé pour des très petits motifs (22 nm), la délimitation des motifs à imprimer se fait cette fois par modulation de la phase du signal réfléchi en structurant la surface, par exemple, par gravure du multicouche 4, 4-1 (voir figure 2).

Le déphasage $\Delta\Phi$ introduit entre les zones gravées et non gravées, c'est-à-dire entre les réflexions R1 et R2, dépend de la différence de marche optique, et donc de l'épaisseur $\Delta\varepsilon$ gravée de multicouche. L'objectif est de garantir un contraste suffisamment élevé au passage de la marche (passage R1=>R2). De façon schématique, on considère que le contraste dépend de l'écart de $\Delta\Phi$ par rapport à 180°. Autrement dit, il est maximal lorsque $\Delta\Phi$ vaut exactement 180°.

Les spécifications courantes de lithographie imposent au moins un certain contraste pour garantir un profil de gravure correct de la résine. Cette contrainte revient à garantir un déphasage des signaux R1 et R2 de $\Delta\Phi = 180 \pm 5°$, soit une précision sur la profondeur de gravure $\Delta\varepsilon$ de $\pm$ 1 Å.

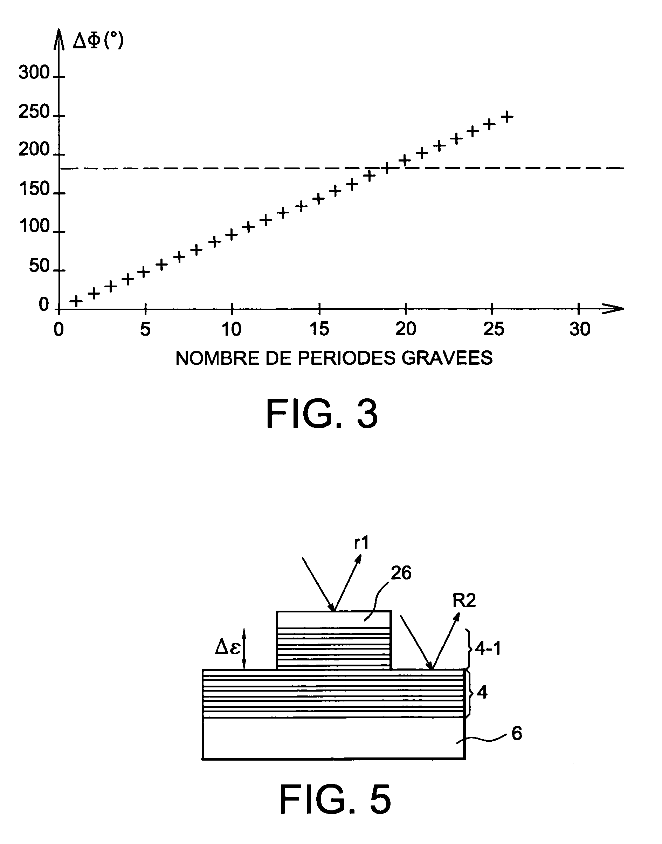

Cette précision découle de la relation linéaire qui lie le déphasage $\Delta\Phi$ et la profondeur de gravure $\Delta\varepsilon$. Un exemple de calcul du déphasage dans le cas d'un multicouche périodique Mo/Si est présenté en figure 3. On observe que le déphasage vaut 180° après gravure de 19 à 20 paires Mo/Si.

Technologiquement, une maîtrise de la gravure à $\pm$ 1 Å est très difficile. Cela suppose non seulement de savoir arrêter la gravure avec une très grande précision mais également de maîtriser parfaitement l'homogénéité de gravure. Actuellement, les précisions courantes atteintes en matière de gravure sont plutôt de l'ordre de $\pm$1 nm. Pour cela, et pour faciliter l'arrêt de la gravure, on a en général recours à une couche d'arrêt 20 insérée dans l'empilement (voir figure 4), entre les portions 4 et 4 - 1 du multicouche. Cette couche 20 est optiquement neutre (épaisseur : modulo λ/2n, n étant l'indice optique de la couche d'arrêt) et présente une bonne sélectivité de gravure par rapport à l'empilement.

Enfin, une autre variante de masques EUV PSM consiste à ajouter sur le multicouche une couche 26 absorbante (figure 5) pour diminuer R1. Ce type de masque est connu sous l'appellation de masque à décalage de phase atténué.

Il se pose donc le problème de contrôler des épaisseurs de marche à l'angström près pour la fabrication de composants optiques, et notamment de masques EUV à décalage de phase.

## EXPOSÉ DE L'INVENTION

L'invention propose une structure de composant optique, et en particulier de masque, tel que par exemple un masque à décalage de phase dans l'EUV, et un procédé de réalisation associé, permettant d'ajuster, après gravure, le déphasage $\Delta\Phi$ à $\pm$ 5°, soit l'écart de marche géométrique $\Delta\varepsilon$ à une bonne précision, inférieure à quelques fractions de nm, et de préférence de l'ordre de $\pm$ 1 Å.

L'invention concerne d'abord un procédé de formation d'un composant optique comportant :

a- la formation d'un empilement multicouches avec une couche d'ajustement en un mélange métal - semi-conducteur formée dans ou sur l'empilement, ce mélange étant apte à former après recuit un alliage,
b- la gravure d'une partie de l'empilement multicouche, comportant la gravure d'au moins une partie de la couche d'ajustement,
c- une étape de recuit pour contracter la couche d'ajustement de moins de 1 nm.

Par mélange métal - semi-conducteur, on entend soit un multicouche métal - semi-conducteur, ou encore une matrice de matériau semi-conducteur comportant des agrégats métalliques.

Le matériau semi-conducteur peut en particulier être du silicium ou du germanium.

Le recuit peut être un recuit sous vide.

Ce procédé peut en outre comporter une étape de contrôle de phase par caractérisation optique.

Un procédé selon l'invention permet, par recuit, de contracter la couche d'ajustement jusqu'à ce que le déphasage $\Delta\Phi$, entre un rayonnement réfléchi par une portion gravée du multicouche et le rayonnement réfléchi par une portion non gravée, diminue par exemple à une valeur de l'ordre de, ou inférieure à, 180°$\pm$5°.

L'invention concerne donc également un procédé de formation d'un composant optique comportant :

a- la formation d'un empilement multicouches avec une couche d'ajustement en un mélange métal - semi-conducteur formée dans ou sur l'empilement,
b- la gravure d'une partie de l'empilement multicouche, dont au moins une partie de la couche d'ajustement,
c- une étape de recuit pour réduire le déphasage $\Delta\Phi$ entre un rayonnement réfléchi par une portion gravée du multicouche et le rayonnement réfléchi par une portion non gravée à, par exemple, une valeur de l'ordre de, ou inférieure à, 180°$\pm$5°.

Selon un mode de réalisation, la couche d'ajustement comporte une succession de bicouches métal - Si.

La couche d'ajustement comporte de préférence entre 1 et 10 bicouches.

De préférence, l'étape de recuit est réalisée à une température inférieure à 200°C ou 300°C ou 400°C.

L'invention concerne également un composant optique comportant un empilement multicouches partiellement gravé, avec une couche d'ajustement en un mélange métal - semi-conducteur formée dans ou sur la portion gravée de l'empilement.

L'angle de déphasage entre un rayonnement réfléchi par une portion gravée du multicouche et le rayonnement réfléchi par une portion non gravée est sensiblement égal ou inférieur à 180°$\pm$5°

La couche d'ajustement peut comporter une succession de bicouches métal - Si, par exemple entre 1 et 5 ou 10 bicouches.

Tant dans le procédé que dans le composant suivant l'invention, le métal de la couche d'ajustement est par exemple du molybdène ou du ruthénium ou du Rhodium (Rh) ou du chrome (Cr) ou du Palladium (Pd) ou du platine (Pt) ou du cuivre (Cu) ou du cobalt (Co) ou du nickel (Ni).

La couche d'ajustement peut en outre comporter des couches barrières aux interfaces avec le multicouche.

Ces couches barrières comportent par exemple du carbure de bore ($B_4C$), ou du carbone, ou du carbure de molybdène (MoC), ou du dioxyde de silicium ($SiO_2$), ou du siliciure de molybdène ($MoSi_2$) .

La couche d'ajustement peut être située sur une couche d'arrêt de gravure.

**BREVE DESCRIPTION DES FIGURES**

- Les figures 1 à 5 représentent divers dispositifs de l'art antérieur, la figure 4 représentant un exemple d'évolution du déphasage en fonction du nombre de périodes gravées ;
- les figures 6A à 6C représentent des étapes de réalisation d'un dispositif selon l'invention,
- la figure 7 représente schématiquement un exemple de réalisation d'un dispositif selon l'invention,
- la figure 8 est une variante d'un dispositif selon la présente invention,
- la figure 9 représente encore une autre variante, dans laquelle la couche d'ajustement forme également couche absorbante d'amélioration de contraste,
- les figures 10A et 10B représentent des courbes d'ajustement de l'épaisseur d'un bicouche Mo/Si en fonction de la température et/ou du temps
- la figure 11 est encore un autre exemple d'un dispositif selon l'invention, avec couche absorbante déposée en surface d'un multicouche.

**EXPOSÉ DÉTAILLÉ DE MODES DE RÉALISATION PARTICULIERS**

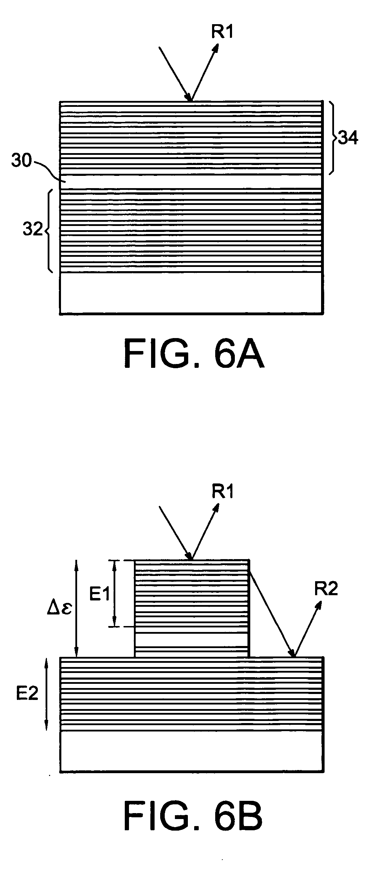

Un premier exemple de réalisation d'un dispositif selon l'invention va être décrit en liaison avec les figures 6A et 6B.

Sur la figure 6A, un composant optique, par exemple un blanc de masque, comporte un empilement multicouche réflecteur EUV 32, 34, dont des exemples de composition seront donnés plus loin, et dans lequel est insérée une couche 30 d'ajustement. Les deux parties 32 et 34 ont respectivement pour épaisseur $E_1$ et $E_2$.

Cette couche d'ajustement 30 présente une composition à base de deux éléments, qui sont préférentiellement un métal et un semi-conducteur, par exemple du silicium), tels que le métal et le semi-conducteur forment un alliage par recuit.

L'épaisseur et les propriétés optiques de cette couche 30 peuvent être ajustées par des recuits à basse température. Le recuit provoque en effet une contraction de la couche 30 due à l'interdiffusion métal/semi-conducteur dans cette couche. Cette interdiffusion modifie également les indices optiques de la couche 30, c'est-à-dire son indice de réfraction n et le coefficient d'extinction k.

Pour ajuster $\Delta\Phi$ on ajuste $\Delta\varepsilon$ et n par le recuit.

L'ajustement envisagé de l'épaisseur est de l'ordre de quelques fractions de nm, par exemple entre 0,1 nm et 0,5 nm ou 1 nm. Par basse température on entend une température suffisamment basse pour ne pas perturber le reste du multi-couche, c'est-à-dire ne pas altérer les propriétés réfléchissantes des couches 32, 34 ; de préférence cette température est inférieure à 300°C. Avantageusement, on choisira une température suffisamment basse pour ne pas modifier l'épaisseur des couches 32, 34, ces couches pouvant également être constituées de bicouches métal/silicium, comme décrit ultérieurement.

Cette couche d'ajustement est située sur ou au-dessus de, la partie 32 non gravée de l'empilement. Pendant le processus d'ajustement, l'épaisseur $\Delta\varepsilon$ et l'indice n varient par contraction de la couche d'ajustement. Avantageusement, dans le même temps, les épaisseurs $E_2$ et $E_1$ restent constantes (voir figure 6B).

L'empilement multicouche réflecteur 32, 34 est préférentiellement une structure périodique, stable thermiquement, de type $Si/Mo_2C$ ou $Si/MoSi_2$ ou à base de couches métalliques (par exemple : Mo, ou Pt) et de Si entre lesquelles peuvent être insérées des couches barrières du type $B_4C$, ou $SiO_2$, ou $Mo_2C$ ou $MoSi_2$.

Ces couches barrières empêchent l'interdiffusion entre métal et silicium, empêchant les modifications d'épaisseur de ces couches ainsi qu'une altération de leurs propriétés optiques.

L'ajustement est obtenu par gravure de l'empilement, de manière à faire en sorte que le déphasage introduit entre R1 et R2 approche la valeur de 180° tout en restant légèrement supérieur à 180°. Ceci peut être obtenu par un contrôle optique in situ pendant la gravure, par exemple à l'aide d'un ellipsomètre, ou par réflectométrie.

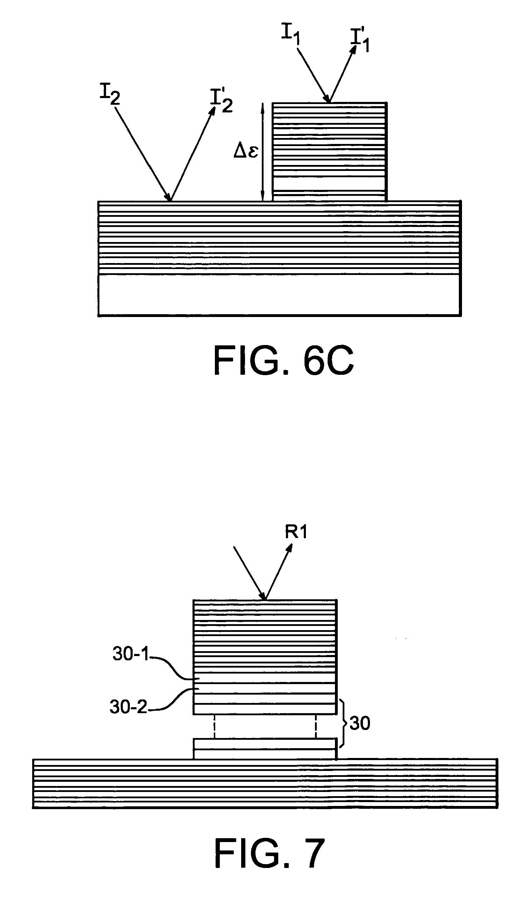

La technique classique de réflectométrie permet de suivre un situ la gravure et/ou la contraction Par exemple, un rayonnement source dans l'EUV, de quelques nanomètres, par exemple 4,47nm est envoyé en incidence non nulle avec une intensité $I_1$ sur l'empilement 34 (figure 6C), et un détecteur permet de suivre le rayonnement réfléchi d'intensité $I'_1$.

Pendant le recuit, on peut uniquement suivre l'évolution au niveau de la zone contenant la couche 30, ce qui suppose que $E_2$ ne soit pas modifiée.

Il est également possible de faire un suivi d'un déphasage par mesure différentielle : deux rayonnements incidents, d'intensité $I_1$ et $I_2$ sont envoyés respectivement sur l'empilement 34 et sur la partie gravée, des rayonnements $I'_1$ et $I'_2$ étant respectivement réfléchis, à partir desquels une mesure différentielle peut être effectuée.

Par exemple, dans l'exemple de la figure 3 précédente, cela revient à graver 19 paires de MoSi et partiellement

la 20ème paire. Soit la couche 34 a exactement le nombre de paires requis et la couche 32 est non gravée, soit la couche 34 n'a pas suffisamment de paires et on grave entièrement la couche 34 puis la couche 30, puis le nombre de paires nécessaire manquant dans la couche 32.

Cette gravure aboutit par exemple à la structure de la figure 6B.

Ensuite, par recuit, on contracte la couche d'ajustement 30 jusqu'à ce que le déphasage $\Delta\Phi$ diminue par exemple à une valeur de l'ordre de, ou inférieure à, 180°$\pm$5°. Cet ajustement peut se faire par contrôle optique pendant le recuit, comme décrit précédemment. L'avantage de cette technique d'ajustement est qu'elle requiert un simple recuit pleine plaque du masque pendant quelques heures au maximum.

Ce recuit se fait préférentiellement sous vide et peut donc par exemple être réalisé dans le même bâti que la gravure ionique de l'empilement multicouche avec contrôle de la phase par caractérisation optique EUV in situ.

Entre les étapes de gravure et de recuit il peut y avoir une étape d'enlèvement de la résine utilisée pour définir les contours de gravure.

Cette méthode de recuit pleine plaque ne nécessite donc pas le recours à des techniques d'écriture électroniques coûteuses et consommatrices de temps.

L'invention met donc en oeuvre une couche d'ajustement spécifique, distincte des couches 32, 34.

Comme illustré sur la figure 7, la couche 30 peut comporter du silicium 30 - 1, dans lequel on a introduit un métal, préférentiellement sous forme d'une ou de plusieurs couches fines métalliques 30 - 2.

Le métal peut également se présenter sous forme d'agrégats.

Lors du dépôt de métal 30 - 2 sur le silicium 30 - 1, il se forme une zone d'interdiffusion amorphe comprenant un composé métal-silicium de quelques angströms ou de quelques nanomètres d'épaisseur. Un recuit à basse température (inférieure à 300°C) entraîne une légère croissance ou réorganisation atomique de cette zone d'interdiffusion.

Du fait des différences de densité entre le métal, le silicium et le siliciure susceptible de se former, cette modification de la couche d'interface résulte en une contraction de la couche 30.

Par exemple, dans le cas du couple Mo-Si, suivant le composé formé ($Mo_3Si$ ou $Mo_5Si_3$ ou $MoSi_2$), on aura les niveaux de contraction indiqués dans le tableau 1 suivant. Les valeurs des épaisseurs sont normalisées : ainsi, pour 1 nm (respectivement 2 nm) de Mo et 0,4 nm (resp. 0,8 nm) de Si, on forme 1,2 nm de $Mo_3Si$ (resp. 2,4 nm).

Tableau I

| Couche : composé formé | $Mo_3Si$ | $Mo_5Si_3$ | $MoSi_2$ |
|---|---|---|---|
| Epaisseur consommée de Mo | 1 | 1 | 1 |
| Epaisseur consommée de Si | 0,4 | 0,8 | 2,5 |
| Epaisseur de siliciure formé | 1,2 | 1,4 | 2,4 |
| Taux de concentration | -14 % | -22 % | -31 % |

L'invention met donc en oeuvre une couche de contraction 30 dans laquelle se produit un phénomène d'interdiffusion entre un métal et le matériau semi-conducteur, entraînant une contraction de l'ensemble ajustable par traitement thermique.

Le niveau de contraction obtenu dépend des densités respectives et des concentrations en matériau semi-conducteur des alliages formés. Quelques exemples sont donnés dans le tableau II ci-dessous pour le silicium, tableau qui indique, pour chaque métal, le coefficient K d'absorption optique, l'indice de réfraction N, la température T de formation d'un siliciure avec le silicium, la densité du métal et la densité du composé siliciure, et enfin le degré de contraction.

TABLEAU II

| Matériau | Si | Mo | Ru | Rh | Cr | Pd | Pt | Cu | Co | Ni |
|---|---|---|---|---|---|---|---|---|---|---|
| K | 0.002 | 0.006 | 0.017 | 0.032 | 0.039 | 0.046 | 0.060 | 0.061 | 0.066 | 0.072 |
| N | 0.999 | 0.922 | 0.889 | 0.873 | 0.931 | 0.877 | 0.891 | 0.963 | 0.933 | 0.948 |
| Composé (T°C)* | - | $MoSi_2$ 420°C | $Ru_2Si_3$ 350°C | RhSi 350°C | $CrSi_2$ 520°C | $Pd_2Si$ 175°C | $Pt_2Si$ 250°C | $cu_3si$ 150°C | CoSi2 350°C | $Ni_2Si$ |
| Densité métal | - | 10.2 | 12.2 | 12.4 | 7.19 | 12 | 21.4 | 8.96 | 8.9 | 8.9 |

(suite)

| Matériau | Si | Mo | Ru | Rh | Cr | Pd | Pt | Cu | Co | Ni |
|---|---|---|---|---|---|---|---|---|---|---|
| Densité ** composé/ contraction | - | 6.24 / -31% | | 8.3 / -22% | 4.9 / -29% | | | | 5.3 / -29% | 7.2 / -20% |
| *valeurs typiques mesurées en couche mince<br>** valeurs connues pour les matériaux massifs | | | | | | | | | | |

Par exemple, la colonne « Mo » se lit de la manière suivante : le recuit d'un mélange Mo/Si à 420°C forme du $MoSi_2$, l'épaisseur de cette couche de $MoSi_2$ correspondant à la somme de l'épaisseur de Mo et de l'épaisseur de Si initiales x 0,69 :

$$e_{MoSi2} = (e_{Mo} + e_{Si}) \times 0{,}69.$$

Dans le cas du couple Mo-Si, des données expérimentales montrent que, à température constante, le temps de recuit permet de contrôler la réduction d'épaisseur due à la contraction avec une très grande précision, inférieure à l'angström à très basse température (voir plus loin l'exemple 1).

De préférence, la couche ajustable 30, par exemple à base de Mo et de Si, sous forme de bicouche ou multicouche, comporte à l'interface avec les couches 32 et 34 des couches barrières (de composition $B_4C$, ou C, ou MoC, ou $SiO_2$, ou $MoSi_2$ etc...) pour éviter les phénomènes d'interdiffusion entre les couches 30 et les couches 32, 34.

Le ruthénium (Ru) peut également être utilisé en remplacement du molybdène dans la couche 30.

Le tableau II montre en effet que cet élément Ru, tout en conservant une absorption optique raisonnable (k= 0,017) comparée à celle du Mo, forme un composé défini avec Si à une température relativement faible et donne également naissance à un phénomène de contraction.

Les couches ajustables ont de préférence une épaisseur quart d'onde (e=λ/4n) pour contribuer à augmenter la réflexion R1 dans la partie supérieure 34 du multicouche.

Ceci est possible, notamment dans le cas des métaux Mo et Ru qui ont une relative transparence optique et un indice faible par rapport à Si.

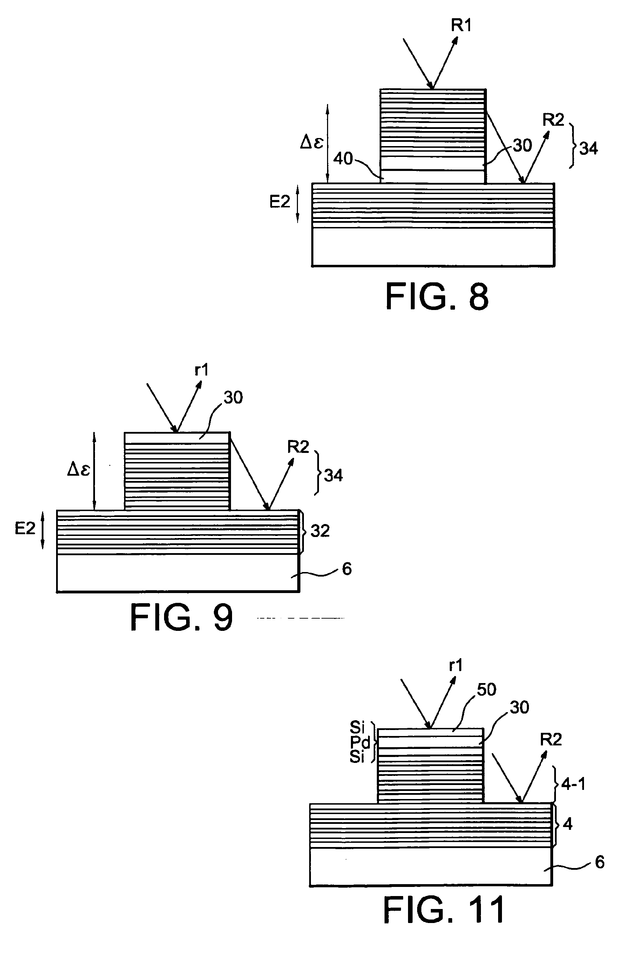

La couche d'adaptation 30 est de préférence située juste au dessus d'une couche 40 d'arrêt de gravure comme indiqué sur la figure 8.

De plus, pour conserver une grande précision d'ajustement avec une résolution de quelques dixièmes d'angström et également pour limiter l'impact de cette couche 30 sur la fonction optique Ri, la couche 30 comporte de préférence un nombre limité de bicouches, par exemple entre 1 et 5 ou 1 et 10.

Pour abaisser encore la température d'ajustement, on peut utiliser, pour la couche 30, des métaux qui forment avec le silicium des siliciures à très basse température.

Dans ce cas, la fonction miroir pourra être assurée par un multicouche 32, 34 non stabilisé même si un multicouche stable thermiquement est toujours préférable.

Par exemple, la couche 30 est en Pd/Si et les couches 32, 34 en Mo/Si. Un recuit est effectué à une température sensiblement égale ou supérieure à 175 °C. En effet, à 175°C on forme $Pd_2Si$ alors qu'à cette température le couple Mo-Si reste stable ($MoSi_2$ ne se formant qu'à partir de 420°C, cf. tableau II).

Le tableau II montre que, dans l'ordre de préférence et de façon non exhaustive, les métaux Pd, Ni, Pt et Cu, constituent de bons candidats. Mo et Ru constituent de bons candidats pour les masques à décalage de phase atténué. Co et Rh sont également utilisables mais de préférence avec un miroir stabilisé.

En effet, à l'instar du chrome, souvent utilisé dans les absorbeurs EUV, tous ces métaux sont relativement absorbants (contrairement à Mo et Ru, qui sont relativement transparents).

Dans ce cas, la couche 30, en plus de son rôle d'ajustement, pourra être utilisée directement comme couche absorbante supérieure (figure 9) ou en association avec une couche absorbante préexistante (dans ce cas cette couche absorbante est également située en haut de l'empilement 34). La structure de la figure 9 peut également comporter une couche d'arrêt de gravure standard telle que décrite dans la figure 4 (au même endroit, c'est-à-dire au pied de la portion 34).

On pourra également, dans le cas de structures de masques à décalage de phase atténué, utiliser du germanium plutôt que du silicium. En effet, le germanium est absorbant dans l'EUV. Son utilisation renforce donc l'absorption optique EUV de la couche d'ajustement.

Des exemples de réalisation vont maintenant être donnés.

Exemple 1 : dans ce premier exemple, la couche d'ajustement 30 est une bicouche Mo-Si.

Elle comporte typiquement 3 nm de Mo déposé sur 4 nm de Si. Cette couche est insérée dans un multicouche stable (avec des couches barrières type B$_4$C) comportant 40 à 50 bicouches Mo/Si de période 7 nm.

La couche d'ajustement 30 est placée préférentiellement juste au dessus de la couche d'arrêt 40 de gravure (structure de la figure 8) pour diminuer son impact sur la valeur de R1.

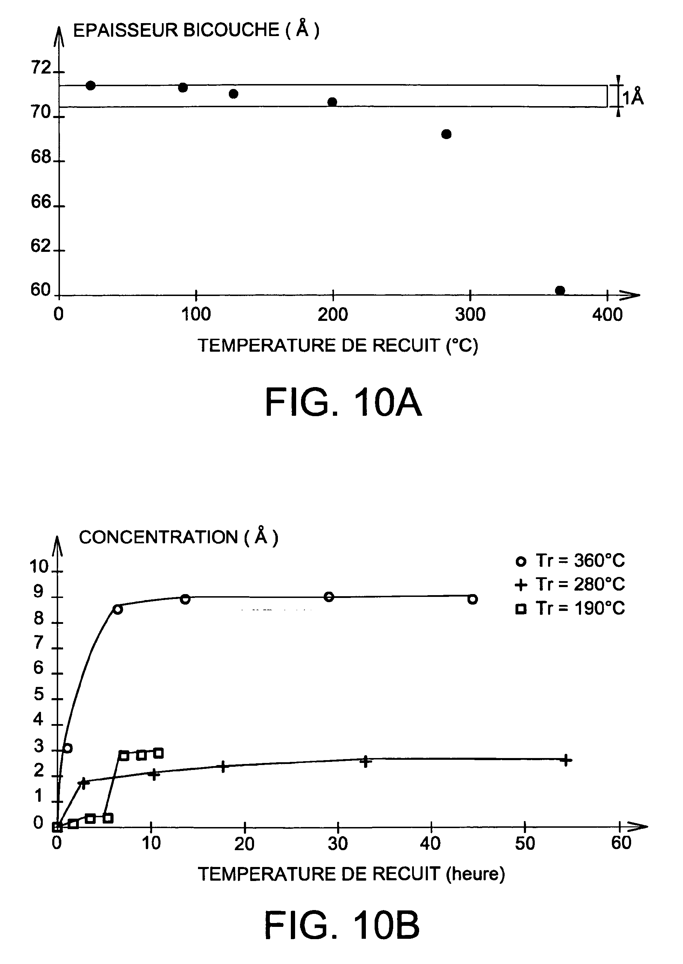

La variation de l'épaisseur de cette couche est donnée en fonction de la température et en fonction du temps sur les figures 10A et 10B.

La figure 10A indique les variations de l'épaisseur du bicouche Mo/Si par recuits successifs cumulés. Chaque recuit se fait sous vide pendant 16 heures. Partant d'une épaisseur initiale d'environ 7 nm, on arrive à une épaisseur finale proche de 6 nm, soit une variation de près de 1 nm.

La figure 10B indique les variations (contractions) de l'épaisseur du bicouche Mo/Si par recuits sous vide à température constante et temps croissants.

A temps de recuit constant, la contraction dépend de la température de recuit. Dans l'exemple de la figure 10A, on voit que l'on peut ajuster l'épaisseur du bicouche 30, dans une gamme de précision inférieure à 1 Å, pour des températures ne dépassant pas 200°C.

De même, la contraction d'une bicouche Mo-Si augmente avec le temps de recuit. On observe que l'on peut contrôler la contraction de la bicouche à quelques dixièmes d'angström près par recuit à 190°C, dans la gamme de 1 à 2 Å par recuit à 280°C et jusqu'à 1 nm par recuit à 360°C.

De plus, ces recuits sont cumulatifs : l'échantillon recuit à 190°C, lorsqu'il est recuit à 360°C (points gris sur la courbe Tr=190°C) suit une loi de contraction parallèle à celle de l'échantillon directement recuit à 360°C (courbe Tr=360°C)

Exemple 2 : la couche d'ajustement 30 comporte une paire de bicouche Mo-Si, chaque bicouche comportant une couche de 2nm de Si et une couche de 1,5 nm de Mo. Les autres paramètres sont identiques à ceux de l'exemple 1. L'avantage est que l'on a, dans ce cas, deux zones d'interdiffusion Mo-Si, donc un effet de contraction double en comparaison de l'exemple 1, toutes choses étant égales par ailleurs.

Exemple 3 : la couche d'ajustement 30 est un mélange de Mo et Si obtenu par co-pulvérisation ou co-évaporation de molybdène et de silicium ; les vitesses de dépôt sont ajustées de manière à déposer deux fois plus de Si que de Mo : on obtient ainsi un matériau composite comportant soit une seule phase de MoSi$_2$ amorphe, soit une phase de Si amorphe avec des agrégats de Mo, soit les deux à la fois. Un recuit adapté provoque une contraction de la couche d'ajustement en homogénéisant cette couche en MoSi$_2$ amorphe.

Exemple 4 : cet exemple est identique aux exemples 1 ou 2, en remplaçant, dans l'empilement 30, Mo par Ru. L'intérêt est que la diffusion de Si dans Ru se fait à plus basse température que dans Mo (voir tableau II). L'ajustement par recuit se fait dans des conditions moins contraignantes pour la fonction du miroir multicouche 32, 34.

Exemple 5 : La couche d'ajustement 30 absorbante, déposée en surface du multicouche Mo-Si (structure de la figure 11) comporte une multicouche (3nm Pd + 4nm Si) en nombre p (nombre de paires Pd - Si), encapsulée par du silicium 50 en surface.

Il s'agit alors d'un masque atténué ajustable à très basse température, environ 100°C, pouvant utiliser un empilement multicouche 32, 34 classique (Mo-Si) ou stabilisé. Cette structure est probablement la plus simple de mise en oeuvre. Le nombre de paires de la couche 30 d'ajustement dépendra de l'atténuation optique recherchée et de la gamme de variation d'épaisseur souhaitée.

La structure de blanc de masque selon l'invention permet :

- de réaliser des masques à décalage de phase pour la lithographie EUV, dont la phase est ajustable par simple recuit pleine plaque à basse température (T < 300°C) dans un environnement contrôlé (sous vide ou non),
- d'ajuster le décalage d'épaisseur, et donc de phase optique, entre la partie gravée et non gravée d'un masque avec une résolution meilleure que l'angström (ou de l'ordre du degré en terme de déphasage),
- de faire cet ajustement avec une précision de l'ordre de l'angstrôm sans dégradation de la fonction optique du miroir multicouche 32, 34,
- de pouvoir réaliser cet ajustement sous vide à la suite directement de la gravure (après enlèvement de la résine).

L'invention a des applications industrielles dans divers domaines, par exemple celui de la lithographie EUV, de la fabrication des blancs de masques, de la fabrication des masques, ou celui de la réalisation de composants optiques EUV, en particulier nécessitant un ajustement précis de la phase (polariseurs, etc...), ou celui de la réalisation de structures gravées (réseaux, motifs enterrés, ...) nécessitant un ajustement dimensionnel précis.

**Revendications**

**1.** Procédé de formation d'un composant optique comportant :

a- la formation d'un empilement multicouche (32, 34) avec une couche d'ajustement (30) en un mélange métal - semi-conducteur formée dans ou sur l'empilement,

b- la gravure d'une partie de l'empilement multicouche, dont au moins une partie de la couche d'ajustement,

c- une étape de recuit pour contracter la couche d'ajustement de moins de 1 nm.

2. Procédé selon la revendication 1, le recuit étant un recuit sous vide.

3. Procédé selon l'une des revendications 1 ou 2, comportant en outre une étape de contrôle, par caractérisation optique du déphasage, pendant la gravure, d'un rayonnement réfléchi par la portion non gravée de l'empilement.

4. Procédé selon l'une des revendications 1 à 3, comportant en outre une étape de contrôle de la différence de phase, pendant le recuit, par caractérisation optique, entre un rayonnement réfléchi par la portion non gravée (32) de l'empilement multicouche et un rayonnement réfléchi par une portion non gravée de la partie gravée (34) de cet empilement.

5. Procédé selon l'une des revendications 1 à 4, la couche d'ajustement (30) comportant une succession de bicouches métal - semi-conducteur.

6. Procédé selon l'une des revendications 1 à 4, la couche d'ajustement (30) comportant une matrice de matériau semi-conducteur comportant des agrégats métalliques.

7. Procédé selon la revendication 5, la couche d'ajustement comportant entre 1 et 10 bicouches.

8. Procédé selon l'une des revendications 1 à 7, la couche d'ajustement comportant des couches barrières aux interfaces avec l'empilement multicouche (32, 34).

9. Procédé selon la revendication 8, les couches barrières comportant du carbure de bore ($B_4C$), ou du carbone, ou du carbure de molybdène (MoC), ou du dioxyde de silicium ($SiO_2$) ou du siliciure de molybdène ($MoSi_2$).

10. Procédé selon l'une des revendications 1 à 9, l'épaisseur de l'empilement multicouche (32, 34) restant sensiblement constant pendant l'étape de recuit.

11. Procédé selon l'une des revendications 1 à 10, la couche d'ajustement (30) étant située sur une couche d'arrêt de gravure (40).

12. Procédé selon l'une des revendications 1 à 11, la couche d'ajustement (30) étant située sur une portion non gravée de la partie (34) gravée du multicouche.

13. Procédé selon la revendication 12, le semi-conducteur étant du germanium.

14. Procédé selon la revendication 12 ou 13, le métal étant du rhodium (Rh) ou du palladium (Pd) ou du platine (Pt) ou du nickel (Ni) ou du cuivre (Cu) ou du cobalt (Co).

15. Procédé selon l'une des revendications 1 à 12, dans lequel le matériau semi-conducteur est du silicium.

16. Procédé selon l'une des revendications 1 à 12, le métal étant du molybdène ou du ruthénium.

17. Procédé selon l'une des revendications 1 à 16, l'étape de recuit étant réalisée à une température inférieure à 400°C.

18. Composant optique comportant un empilement multicouches (32, 34) partiellement gravé, avec une couche (30) distincte et contractante permettant d'ajuster l'épaisseur en un mélange métal - semi-conducteur, formée dans ou sur une portion non gravée de la partie gravée (34) de l'empilement.

19. Composant selon la revendication 18, le matériau semi-conducteur étant du silicium ou du germanium.

20. Composant selon la revendication 18 ou 19, la couche d'ajustement comportant une succession de bicouches métal - Si.

**21.** Composant selon l'une des revendications 18 à 20, la couche d'ajustement comportant entre 1 et 10 bicouches.

**22.** Composant selon l'une des revendications 18 à 21, le métal étant du molybdène ou du ruthénium ou du Rhodium (Rh) ou du chrome (Cr) ou du Palladium (Pd) ou du platine (Pt) ou du cuivre (Cu) ou du cobalt (Co) ou du nickel (Ni).

**23.** Composant selon l'une des revendications 18 à 22, la couche d'ajustement (30) étant située sur une couche d'arrêt de gravure (40).

**24.** Composant selon l'une des revendications 18 à 23, la couche d'ajustement (30) étant située sur la portion non gravée de la partie gravée (34) du multicouche.

**Claims**

**1.** Process for forming an optical Component comprising:

   a- formation of a multi-layer stack (32, 34) with an adjustment layer (30) made of a mental - semiconductor mix formed in or on the stack,
   b- etching a part of the multi-layer stack, including at least a part of the adjustment layer,
   c- an annealing step to contract the adjustment layer within less than 1 nm.

**2.** Process according to claim 1, annealing being done under a vacuum.

**3.** Process according to either claim 1 or 2, also comprising a step to control, during etching, the phase shift of a radiation reflected by the unetched portion of the stack, by optical characterization.

**4.** Process according to one of claims 1 to 3, also comprising a step to control during annealing the phase difference between radiation reflected by the unetched portion (32) of the multi-layer stack and radiation reflected by an unetched portion of the etched part (34) of this stack, by optical characterization.

**5.** Process according to one of claims 1 to 4, the adjustment layer (30) comprising a sequence of metal - semiconductor bilayers.

**6.** Process according to one of claims 1 to 4, the adjustment layer (30) comprising a semiconducting material matrix comprising metallic aggregates.

**7.** Process according to claim 5, the adjustment layer comprising between 1 and 10 bilayers.

**8.** Process according to one of claims 1 to 7, the adjustment layer comprising barrier layers at the interfaces with the multi-layer stack (32, 34).

**9.** Process according to claim 8, the barrier layers including boron carbide ($B_4C$), or carbon, or molybdenum carbide (MoC), or silicon dioxide ($SiO_2$), or molybdenum silicide ($MoSi_2$).

**10.** Process according to one of claims 1 to 9, the multi-layer stack thickness (32, 34) remaining approximately constant during the annealing step.

**11.** Process according to one of claims 1 to 10, the adjustment layer (30) being located on an etching stop layer (40).

**12.** Process according to one of claims 1 to 11, the adjustment layer (30) being located on an unetched portion of the etched part (34) of the multi-layer.

**13.** Process according to claim 12, the semiconductor being germanium.

**14.** Process according to claim 12 or 13, the metal being rhodium (Rh) or palladium (Pd) or platinum (Pt) or nickel (Ni) or copper (Cu) or cobalt (Co) .

**15.** Process according to one of claims 1 to 12, in which the semiconducting material is silicon.

**16.** Process according to one of claims 1 to 12, in which said metal is molybdenum or ruthenium.

**17.** Process according to one of claims 1 to 16, the annealing step being done at a temperature less than 400°C.

**18.** Optical component comprising a partially etched multi-layer stack (32, 34), with a contracting and distinct adjustment layer (30), to adjust thickness, made of a metal - semiconductor mix formed in or on an unetched portion of the etched part (34) of the stack.

**19.** Component according to claim 18, the semiconducting material being silicon or germanium.

**20.** Component according to claim 18 or 19, the adjustment layer comprising a sequence of metal - Si bilayers.

**21.** Component according to one of claims 18 to 20, the adjustment layer comprising between 1 and 10 bilayers.

**22.** Component according to one of claims 18 to 21, the metal being molybdenum or ruthenium or Rhodium (Rh) or chromium (Cr) or Palladium (Pd) or platinum (Pt) or copper (Cu) or cobalt (Co) or nickel (Ni).

**23.** Component according to one of claims 18 to 22, the adjustment layer (30) being located on an etching stop layer (40).

**24.** Component according to one of claims 18 to 23, the adjustment layer (30) being located on the unetched portion of the etched part (34) of the multi-layer.

**Patentansprüche**

**1.** Verfahren zur Herstellung eines optischen Bauteils, das Verfahren umfassend:

a - das Ausbilden eines mehr-bzw. viellagigen Schichtstapels (32, 34) mit einer Einstell-bzw. Justierschicht (30) aus einem in oder auf dem Schichtstapel erzeugten Metall-Halbleiter-Gemisch,
b - die Ätzung eines Teils des mehr-bzw.viellagigen Schichtstapels unter Einschluß wenigstens eines Teils der Einstell-bzw. Justierschicht,
c - eine Verfahrensstufe der Glüh- bzw. Vergütungsbehandlung zum Kontrahieren bzw. Schrumpfen der Einstell-bzw. Justierschicht von weniger als 1 nm.

**2.** Verfahren nach Anspruch 1, bei welchem die Glüh-bzw. Vergütungsbehandlung eine Vergütung unter Vakuum ist.

**3.** Verfahren nach einem der Ansprüche 1 oder 2, welches des weiteren eine Verfahrensstufe der Kontrolle der Phasenverschiebung während der Ätzung umfasst mittels optischer Charakterisierung, einer durch den nicht geätzten Teil des Schichtstapels reflektierten Strahlung.

**4.** Verfahren nach einem der Ansprüche 1 bis 3, welches des weiteren eine Verfahrensstufe der Kontrolle der Phasendifferenz während der Glüh-bzw. Vergütungsbehandlung umfasst, mittels optischer Charakterisierung, zwischen einer durch den nicht- geätzten Teil (32) des mehr- bzw. viellagigen Schichtstapels reflektierten Strahlung und einer durch eine nicht geätzte Portion des geätzten Teil (34) dieses Schichtstapels reflektierten Strahlung.

**5.** Verfahren nach einem der Ansprüche 1 bis 4, wobei die Einstell-bzw, Justierschicht (30) eine Aufeinanderfolge von Metall-Halbleiter-Doppelschichten umfaßt.

**6.** Verfahren nach einem der Ansprüche 1 bis 4, wobei die Einstell-bzw. Justierschicht (30) eine metallische Zusätze umfassende Halbleiter-Matrix aufweist.

**7.** Verfahren nach Anspruch 5, bei welchem die Einstell- bzw. Justierschicht zwischen 1 und 10 Doppelschichten umfaßt.

**8.** Verfahren nach einem der Ansprüche 1 bis 7, bei welchem die Einstell- bzw. Justierschicht Sperrschichten an den Interfacestellen mit dem mehr-bzw. viellagigen Schichtstapel (32, 34) umfaßt.

**9.** Verfahren nach Anspruch 8, bei welchem die Sperrschichten Borkarbid (B$_4$C) oder Kohlenstoff oder Molybdäncarbid

(MoC) oder Siliziumdioxid (SiO$_2$) oder Molybdänsilizid (MoSi$_2$) aufweisen.

10. Verfahren nach einem der Ansprüche 1 bis 9, bei welchem die Dicke des mehr-bzw.viellagigen Schichtstapels (32, 34) während der Glüh-bzw. Vergütungsstufe im wesentlichen konstant bleibt,

11. Verfahren nach einem der Ansprüche 1 bis 10, bei welchem die Einstell-bzw. Justierschicht (30) auf einer Ätzstoppschicht angeordnet ist.

12. Verfahren nach einem der Ansprüche 1 bis 11, bei welchem die Einstell-bzw. Justierschicht (30) auf einer nicht geätzten Portion des geätzten Teil (34) der viellagigen Schicht angeordnet ist.

13. Verfahren nach Anspruch 12, bei welchem der Halbleiter Germanium ist.

14. Verfahren nach Anspruch 12 oder 13, bei welchem das Metall Rhodium (Rh) oder Palladium (Pd) oder Platin (Pt) oder Nickel (Ni) oder Kupfer (Cu) oder Kobalt (Co) ist.

15. Verfahren nach einem der Ansprüche 1 bis 12, bei welchem das Halbleitermaterial Silizium ist.

16. Verfahren nach einem der Ansprüpche 1 bis 12, bei welchem das Metall Molybdän oder Ruthenium ist.

17. Verfahren nach einem der Ansprüche 1 bis 16, bei welchem die Verfahrensstufe der Glüh-bzw. Vergütungsbehandlung bei einer Temperatur unterhalb 400 °C vorgenommen wird.

18. Optisches Bauteil, welches einen teilsweise geätzten mehr-bzw. viellagigen Schichtstapel (32, 34) aufweist, mit einer ihn oder auf einer nicht geätzten Portion des geätzten Teil (34) des Schichtstapels ausgebildeten distinkten und eine Kontraktion bzw. Schrumpfung der Dicke gestattenden Schicht (30) aus einem Metall-Halbleiter-Gemisch.

19. Bauteil nach Anspruch 18, bei welchem das Halbleitermaterial Silizium oder Germanium ist.

20. Bauteil nach Anspruch 18 oder 19, bei welchem die Einstell-bzw. Justierschicht eine Aufeinanderfolge von Metall-Silizium-Doppelschichten umfaßt.

21. Bauteil nach einem der Ansprüche 18 bis 20, bei welchem die Einstell- bzw. Justierschicht zwischen 1 und 10 Doppelschichten umfaßt.

22. Bauteil nach einem der Ansprüche 18 bis 21, bei welchem das Metall Molybdän oder Ruthenium oder Rhodium (Rh) oder Chrom (Cr) oder Palladium (Pd) oder Platin (Pt) oder Kupfer (Cu) oder Kobalt (Co) oder Nickel (Ni) ist.

23. Bauteil nach einem der Ansprüche 18 bis 22, bei welchem die Einstell-bzw: Justierschicht (30) auf einer Ätzstoppschicht (40) angeordnet ist.

24. Bauteil nach einem der Ansprüche 18 bis 23, bei welchem die Einstell-bzw. Justierschicht (30) auf der nicht geätzten Portion des geätzten Teil (34) des mehr-bzw. viellagigen Gebildes angeordnet ist.

FIG. 1

FIG. 2

FIG. 4

FIG. 3

FIG. 5

FIG. 6A

FIG. 6B

FIG. 6C

FIG. 7

R1

Δε

E2

40

30

R2

34

## FIG. 8

r1

30

Δε

E2

R2

34

32

6

## FIG. 9

r1

50

30

Si
Pd
Si

R2

4-1

4

6

## FIG. 11

FIG. 10A

FIG. 10B